# EUROPÄISCHE PATENTSCHRIFT

(11) **EP 3 931 623 B1**
(45) Veröffentlichungstag und Bekanntmachung des Hinweises auf die Patenterteilung: **11.01.2023**
(21) Anmeldenummer: 20713173.1
(22) Anmeldetag: 26.02.2020
(51) Int. Cl.: G02B 26/08, B81B 3/00

(54) **MIKROMECHANISCHE STRUKTUR UND VERFAHREN ZUM BEREITSTELLEN DERSELBEN**
MICROMECHANICAL STRUCTURE AND METHOD FOR PROVIDING SAME
STRUCTURE MICROMÉCANIQUE ET PROCÉDÉ DE FOURNITURE DE CELLE-CI

(30) Priorität: 27.02.2019 DE 102019202658; 27.02.2019 DE 102019202656
(43) Veröffentlichungstag der Anmeldung: 05.01.2022
(73) Patentinhaber: Fraunhofer-Gesellschaft zur Förderung der angewandten Forschung e.V., 80686 München (DE)
(72) Erfinder: DRABE, Christian, 01109 Dresden (DE); KAISER, Bert, 01109 Dresden (DE)
(74) Vertreter: Zimmermann, Tankred Klaus
(86) Internationale Anmeldenummer: PCT/EP2020/055000
(87) Internationale Veröffentlichungsnummer: WO 2020/173989

(56) Entgegenhaltungen:
- JP-A- 2006 167 860
- JP-A- 2015 229 220
- US-A1- 2015 203 346
- US-A1- 2018 017 783

## Beschreibung

Die vorliegende Erfindung bezieht sich auf eine mikromechanische Struktur mit einem beweglichen Element, das durch eine Auslenkung einer Torsionsfeder auslenkbar ist. Die vorliegende Erfindung bezieht sich ferner auf ein Verfahren zum Bereitstellen einer derartigen mikromechanischen Struktur.

Um mikro-elektro-mechanische Systeme (MEMS), etwa Mikrospiegel oder Mikrogitter, aus ihrer Ebene heraus (out-of-plane) zu bewegen, bieten sich neben diversen physikalischen Methoden, wie beispielsweise der magnetischen, der piezoelektrischen und der akustischen, auch elektrostatische Methoden an.

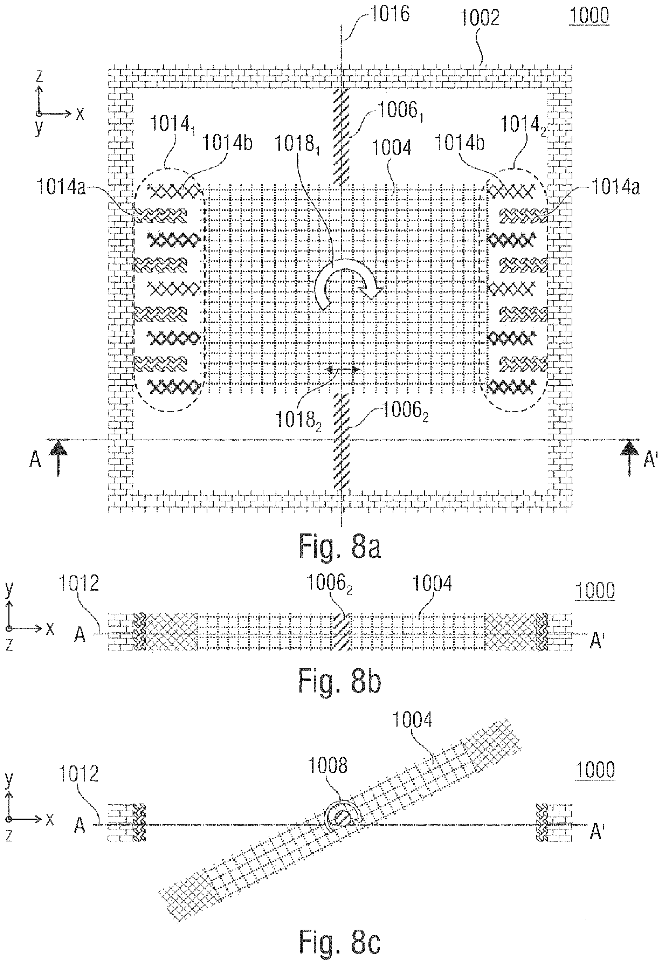

Ein bekanntes System 1000 ist in einer schematischen Aufsicht in Fig. 8a dargestellt. Zwischen einem Rahmen 1002 und einem Mikrospiegel 1004 sind Torsionsfedern 1006 angeordnet. Fig. 8b zeigt eine schematische Seitenschnittansicht in einer Schnittebene A-A' der Vorrichtung 1000, in welcher das rechteckige Profil der Torsionsfedern 1006 an den Widerlagern, d. h., an dem Substrat 1002, erkennbar ist. Die Torsionsfedern 1006 ermöglichen eine in Fig. 8c dargestellte Torsionsbewegung 1008 des Nutzelements 1004 aus einer Referenzebene 1012 heraus. Die runde Darstellung der Federprofile oder Querschnitte in Fig. 8c deutet an, dass die Torsionsfedern ausgelenkt, d. h., tordiert sind, obwohl bei lokaler Betrachtung ein polygoner Querschnitt der Torsionsfedern im Wesentlichen polygon bleiben kann.

Bei einem lateral in der Referenzebene 1012 positionierten Antriebssystem, wie z. B. Paaren 1014₁ und 1014₂ von Elektroden 1014a und 1014b, entstehen beim Anlegen einer elektrischen Spannung zwischen den Elektroden 1014a und 1014b Kräfte, die Bewegungen in unterschiedlichen Freiheitsgraden bewirken können. Neben der im gezeigten ausgelenkten Fall, siehe Fig. 8c, gewünschten rückstellenden Kraft, die ein um eine Rotationsachse 1016 wirkendes Torsionsmoment erzeugt, um eine resonante Schwingung anzuregen, wie es beispielsweise in EP 1 123 526 B1 beschrieben ist, kann das auszulenkende Element 1004 auch durch parasitäre, d. h. nicht für die eigentliche Bewegung gewünschte Kräfte, in Richtung von demgemäß parasitären Freiheitsgraden ausgelenkt werden, wie es beispielsweise durch die Bewegungspfeile 1018₁ und 1018₂ angedeutet ist. Der Bewegungspfeil 1018₁ deutet dabei beispielsweise eine Rotation des Mikrospiegels 1004 in einer x/z-Ebene an, die senkrecht zu der gewünschten Torsionsbewegung 1008 um eine z-Achse bzw. eine Achse parallel hierzu erfolgt. Der Bewegungspfeil 1018₂ deutet eine laterale Verschiebung entlang einer positiven und/oder negativen x-Richtung an, wobei prinzipiell beliebige parasitäre Bewegungen auftreten können.

Durch die parasitären Bewegungen kommt es z. B. durch die lateral angeordneten Elektrodenkämme in den Paaren 1014₁ und 1014₂ zu einer Rotation oder Translation in der x/z-Ebene, das bedeutet in-plane. Eine sogenannte Pull-in-Spannung, bei der es zu einem Einschnappen des auszulenkenden Elements 1004 kommt, begrenzt demnach die eigentlich gewünschte Auslenkung, da das anlegbare elektrische Potential begrenzt wird. Dies führt zu einer Begrenzung der einkoppelbaren/nutzbaren Energie der eigentlichen Nutzmode.

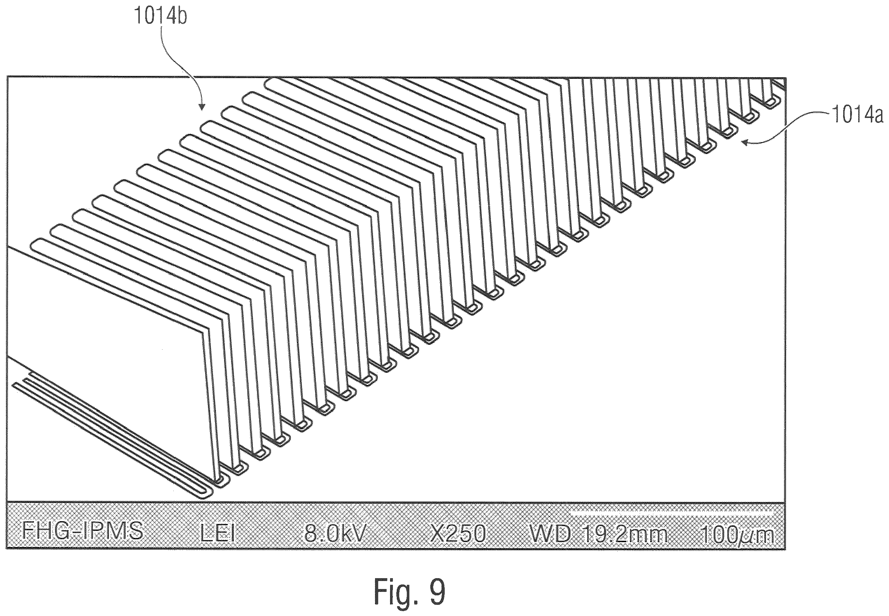

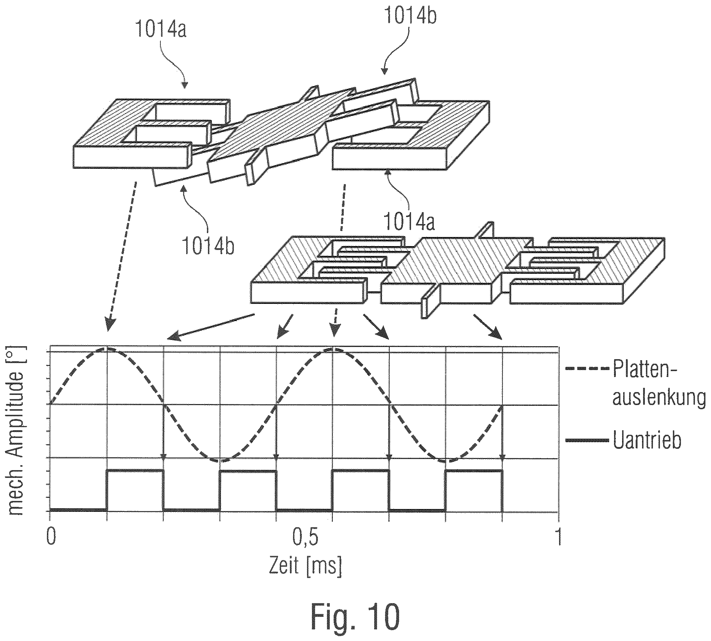

Fig. 9 zeigt eine beispielhafte perspektivische Aufnahme eines Raster-Elektronen-Mikroskops (REM) von Interdigitalelektroden 1014a und 1014b in aus der Ebene heraus ausgelenktem Zustand, bei denen durch Anlegen einer elektrischen Spannung eine anziehende Kraft zwischen den Interdigitalelektroden 1014a und 1014b erzeugt werden kann. Wenn die Elektroden (Kämme) im Ruhezustand (Null-Lage) in der gleichen Ebene liegen, können durch Anlegen einer geeigneten Rechteckspannung in der Nähe des Doppelten der Resonanzfrequenz die Bauelemente in eine resonante Schwingung versetzt werden, wie es in der Fig. 10 dargestellt ist. Hierbei greifen die Elektrodenkämme in Ruhelage ineinander. In anderen Worten zeigt Fig. 10 eine Prinzipskizze zum resonanten Betrieb mikromechanischer Bauelemente. Eine Rechteckspannung mit der doppelten Frequenz der Resonanzfrequenz erzeugt den Antrieb, im oberen und unteren Umkehrpunkt der Schwingung wird die beschleunigte Spannung zugeschaltet, in der Ruhelage abgeschaltet.

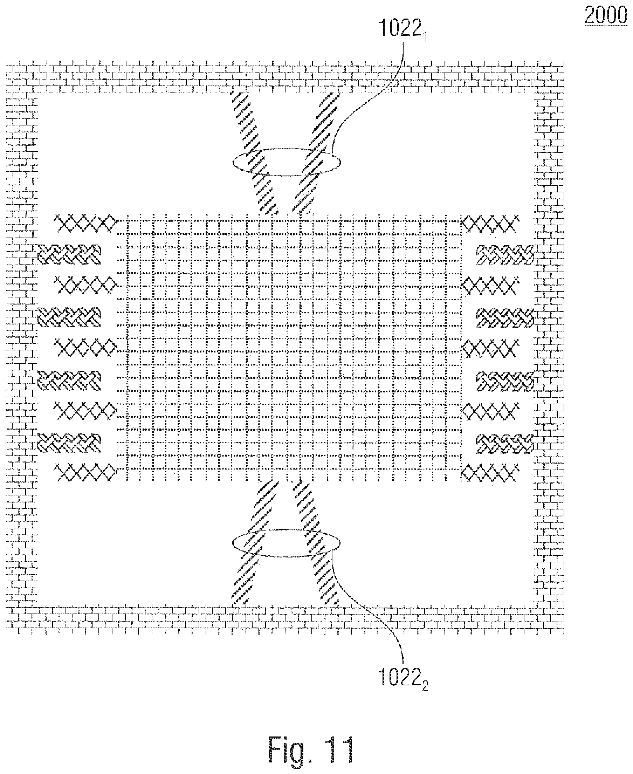

In der Literatur werden alternative Federformen aufgezeigt, die einer lateralen Bewegung eines Elements entgegenwirken sollen, z. B. eine V-förmige Torsionsfederanordnung 1022₁ und 1022₂ eines bekannten mikro-elektro-mechanischen Systems 2000, das in Fig. 11 schematisch dargestellt ist.

Diese weisen jedoch das Problem auf, dass hierdurch zwar der Widerstand einer klassischen Torsionsfeder gegenüber translatorischen und rotatorischen Kräften in der Ebene erhöht wird, dies aber gleichzeitig zu einer Erhöhung der wirkenden Torsionssteifigkeit führt, was unerwünscht ist.

US 2018/0017783 A1 beschreibt einen Scanner-Spiegel in unterschiedlichen Konfigurationen.

US 2015/0203346 A1 beschreibt einen Aktuator mit einem beweglichen Teil und einem stützenden Teil, der den beweglichen Teil stützt. Abschnittsweise gerade Elemente sind in der Fig. 8 dargestellt.

JP 2006-167860 beschreibt einen polygonen Spiegel, der beispielsweise in einem Laserdrucker eingesetzt wird. Ein Connecting Member ist gerundet oder gekrümmt.

JP 2015-229220 beschreibt ein MEMS mit einem Torsionselement.

Wünschenswert wären Torsionsfederanordnungen, die sowohl einen hohen Widerstand gegenüber translatorischen in-plane-Kräften und rotatorischen Kräften aufweisen, dabei aber zu einer geringen oder gar vernachlässigbaren Erhöhung der Torsionssteifigkeit führen.

Eine Aufgabe der vorliegenden Erfindung besteht deshalb darin, Torsionsfederanordnungen zu schaffen, die einen hohen Widerstand gegenüber unerwünschten bzw. parasitären in-plane-Bewegungen bieten, dabei aber zu einer geringen oder vernachlässigbaren Erhöhung der Torsionssteifigkeit gegenüber einer einzelnen Torsionsfeder führen.

Diese Aufgabe wird durch den Gegenstand der unabhängigen Patentansprüche gelöst.

Ein Kerngedanke der vorliegenden Erfindung besteht darin, erkannt zu haben, dass durch lediglich partielle Annäherung der Torsionsfedern aneinander der erzielte Effekt erhalten werden kann, das bedeutet, eine Torsionsfeder mit erhöhter Widerstandskraft gegenüber lateralen Kräften bei gleichbleibender oder lediglich vernachlässigbarer Erhöhung der Torsionsfedersteifigkeit zu erhalten.

Erfindungsgemäß umfasst eine mikromechanische Struktur ein erstes mikromechanisches Element und ein zweites mikromechanisches Element. Die mikromechanische Struktur umfasst eine Torsionsfederanordnung mit einem ersten Torsionsfederelement, das an einem ersten Kontaktbereich mit dem ersten mikromechanischen Element und an einem zweiten Kontaktbereich mit dem zweiten mikromechanischen Element verbunden ist. Die Torsionsfederanordnung umfasst ferner ein zweites Torsionsfederelement, das an einem dritten Kontaktbereich mit dem ersten mikromechanischen Element und an einem vierten Kontaktbereich mit dem zweiten mikromechanischen Element mechanisch verbunden ist. Die Torsionsfederanordnung ermöglicht eine relative Bewegung des ersten mikromechanischen Elements bezüglich des zweiten mikromechanischen Elements. Die Torsionsfederelemente weisen jeweils eine Mittellinie auf, etwa eine geometrische Mittellinie oder eine Linie, die durch Verbinden von Flächenschwerpunkten von Querschnitten der Torsionsfederelemente entlang einer axialen Erstreckungsrichtung derselben erhalten wird. Ein Abstand zwischen den Mittellinien ist ausgehend von dem ersten und dritten Kontaktbereich hin zu dem zweiten bzw. vierten Kontaktbereich in einem ersten Abschnitt abnehmend und in einem zweiten Abschnitt zunehmend. Dies ermöglicht eine Erhöhung der lateralen Steifigkeit der Torsionsfedern um einen Faktor von mindestens 2 bis 3 bei zumindest annähernd vergleichbarer Torsionssteifigkeit, wenn die Torsionsfederanordnung mit der Anordnung einer einzelnen Torsionsfeder gemäß Fig. 8a bis Fig. 8c ausgebildet wird.

Erfindungsgemäß umfasst ein Verfahren zum Bereitstellen einer mikromechanischen Struktur ein Bereitstellen eines ersten mikromechanischen Elements und ein Bereitstellen eines zweiten mikromechanischen Elements sowie ein Anordnen einer Torsionsfederanordnung mit einem ersten, eine erste Mittellinie aufweisenden Torsionsfederelement, so dass das erste Torsionsfederelement an einem ersten Kontaktbereich mit dem ersten mikromechanischen Element und an einem zweiten Kontaktbereich mit dem zweiten mikromechanischen Element mechanisch verbunden ist. Ferner wird ein zweites, eine zweite Mittellinie aufweisendes Torsionsfederelement angeordnet, so dass dieses an einem dritten Kontaktbereich mit dem ersten mikromechanischen Element und an einem vierten Kontaktbereich mit dem zweiten mikromechanischen Element mechanisch verbunden ist, um des erste mikromechanische Element und das zweite mikromechanische Element relativ zueinander beweglich zu verbinden. Hierbei kann eine zeitlich sequentielle Anordnung der Torsionsfederelemente erfolgen, es ist jedoch ebenfalls möglich, das erste mikromechanische Element und/oder das zweite mikromechanische Element und/oder die Torsionsfederanordnung ganz oder teilweise aus einem Material herauszubilden, etwa gleichzeitig oder zumindest innerhalb eines Verfahrensschrittes, etwa durch selektives Ätzen eines Halbleitermaterials. Das Verfahren wird so ausgeführt, dass ein Abstand zwischen der ersten Mittellinie und der zweiten Mittellinie ausgehend von dem ersten und dem dritten Kontaktbereich hin zu dem zweiten und vierten Kontaktbereich in einem ersten Abschnitt abnehmend ist und in einem zweiten Abschnitt zunehmend ist. Das erste Torsionsfederelement und das zweite Torsionsfederelement sind in einer Ruhelage der mikromechanischen Struktur berührungsfrei zueinander angeordnet.

Weitere vorteilhafte Ausführungsformen sind in den abhängigen Patentansprüchen definiert.

Nachfolgend werden unter Bezugnahme auf die beiliegenden Zeichnungen bevorzugte Ausführungsbeispiele der vorliegenden Erfindung erläutert. Es zeigen:
- Fig. 1: eine schematische Draufsicht auf ein MMS gemäß einem Ausführungsbeispiel bei dem Torsionsfederelemente eine gekrümmte Form aufweisen;
- Fig. 2: eine weitere schematische Draufsicht auf das MMS aus mit Fig. 1 zur Erläuterung von Mittellinien der Torsionsfederelemente;
- Fig. 3: eine schematische Draufsicht auf ein MMS gemäß einem Ausführungsbeispiei, bei dem die Torsionsfederanordnung so gebildet ist, dass die Torsionsfederelemente abschnittsweise gerade gebildet sind;
- Fig. 4: eine schematische Draufsicht auf ein MMS gemäß einem Ausführungsbeispiel, bei dem der Querschnitt der Torsionsfederelemente entlang eines axialen Verlaufs der jeweiligen Mittellinie nichtlinear veränderlich ist;
- Fig. 5: eine schematische Draufsicht auf ein MMS gemäß einem Ausführungsbeispiel, bei dem der Querschnitt der Torsionsfederelemente entlang eines axialen Verlaufs der jeweiligen Mittellinie linear veränderlich ist;
- Fig. 6a-b: schematische perspektivische Ansichten bekannter MEMS
- Fig. 6c-d: schematische perspektivische Ansichten erfindungsgemäßer MEMS im Größenvergleich zu den MEMS aus Fig. 6a und Fig. 6b;
- Fig. 7a-b: schematische Seitenschnittansichten erfindungsgemäßer MEMS mit einer Anzahl von Federelementen, die größer ist als 2;
- Fig. 8a: eine schematische Draufsicht eines bekannten MMS
- Fig. 8b: eine schematische Seitenschnittansicht des MMS aus Fig. 8a in einem unausgelenkten Zustand des MMS;
- Fig. 8c: eine schematische Seitenschnittansicht des MMS aus Fig. 8a in einem ausgelenkten Zustand des MMS;
- Fig. 9: eine beispielhafte perspektivische REM-Aufnahme von Interdigitalelektroden, bei denen durch Anlegen einer elektrischen Spannung eine anziehende Kraft zwischen Interdigitalelektroden erzeugt werden kann;
- Fig. 10: eine Prinzipskizze zum resonanten Betrieb mikromechanischer Bauelemente; und
- Fig. 11: eine schematische Darstellung eines bekannten mikro-elektro-mechanischen Systems.

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte und/oder Strukturen in den unterschiedlichen Figuren mit den gleichen Bezugszeichen versehen sind, so dass die in unterschiedlichen Ausführungsbeispielen dargestellte Beschreibung dieser Elemente untereinander austauschbar ist bzw. aufeinander angewendet werden kann.

Nachfolgende Ausführungsbeispiele beziehen sich auf mikromechanische Strukturen (MMS), wobei mikromechanische Elemente hierzu relativ zueinander auslenkbar sind, etwa unter Verwendung eines Aktuators. Der Aktuator kann elektrisch oder nicht-elektrisch gebildet sein, beispielsweise als thermischer Aktuator. Ist der Aktuator als elektrischer Aktuator gebildet, beispielsweise als elektrostatischer Aktuator, piezoelektrischer Aktuator, als pneumatischer Aktuator und/oder als hydraulischer Aktuator, so kann das MMS auch als mikro-elektro-mechanisches System (MEMS) bezeichnet werden. Die hierin genutzten Begriffe MMS und MEMS sind deshalb beliebig miteinander kombinierbar oder austauschbar und werden synonym verwendet, es sei denn, es wird auf dezidierte Unterschiede eingegangen.

MEMS und/oder MMS, wie sie in hierin beschriebenen Ausführungsbeispielen dargestellt sind, können beispielsweise im Rahmen einer Halbleiterfertigung hergestellt werden, beispielsweise als komplementärer Metalloxid-Halbleiterprozess (complementary metal oxide semiconductor - CMOS). Dies kann sowohl das Herausbilden von Strukturen aus einer Schichtstruktur oder einer Schichtstapelstruktur umfassen, als auch unter Verwendung von Volumen-Mikromechanik ("bulk-micro-machining") z.B. aus einkristallinen Substraten, beispielsweise durch Ätzprozesse. Geeignete Materialien für die hierin beschriebenen MEMS können beispielsweise Siliziummaterialien, etwa Silizium, Siliziumoxid, Siliziumnitrid und/oder Siliziumoxinitrid umfassen, können jedoch auch andere Materialien, etwa Metalle wie Kupfer, Aluminium oder dergleichen umfassen. Auch können weitere oder andere Halbleitermaterialien verwendet werden, etwa Galliumarsenid.

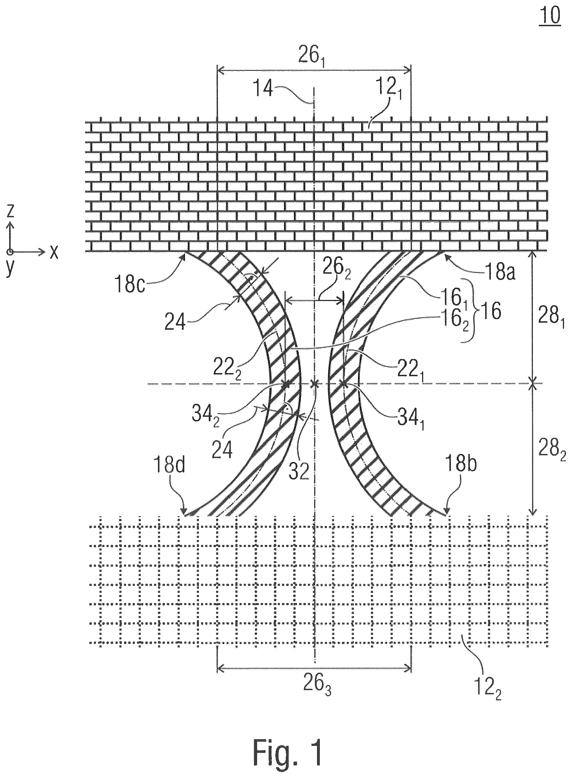

Fig. 1 zeigt eine schematische Draufsicht auf ein MMS 10 gemäß einem Ausführungsbeispiel. Das MMS 10 umfasst ein erstes mikromechanisches Element 12₁ und ein zweites mikromechanisches Element 12₂. Die mikromechanischen Elemente 12₁ und 12₂ sind in dem MMS 10 beweglich zueinander angeordnet, nämlich um eine Torsionsachse 14, die beispielsweise der Torsionsachse 1016 entsprechen kann und in der x/z-Ebene angeordnet sein kann. Bei den mikromechanischen Elementen 12₁ und 12₂ kann es sich um, eine Paarung umfassend, ein als starr anzusehendes Element, etwa ein Substrat, und ein beweglich hierzu angeordnetes Element, etwa ein optisches Element, wie ein Mikrospiegel, ein Mikrogitter oder dergleichen handeln, es können jedoch auch zwei gegenüber einem weiteren Substrat jeweils beweglich angeordnete Elemente implementiert sein. Ein Substrat kann hierbei eine Rahmenstruktur oder eine beliebige andere Referenzstruktur bereitstellen, gegenüber welcher ein anderes Element beweglich ist. Als Rahmen gebildet kann das Substrat an oder auf einem weiteren Substrat angeordnet sein. Beispielsweise kann zumindest eines der Elemente 12₁ und 12₂ Teil einer Hebelübersetzung oder Getriebeübersetzung sein. Ferner ist festzuhalten, dass die hierin beschriebene Anordnung von Antrieben und Torsionsbewegungen nicht auf optische Anwendungen beschränkt ist, sondern vielmehr in sämtlichen Bereichen mikromechanischer Strukturen einsetzbar ist, so dass zumindest eines der mikromechanischen Elemente 12₁ und 12₂ auch Teil eines elektrischen Schalters, eines Ventils oder dergleichen sein kann.

Das MMS 10 umfasst eine Torsionsfederanordnung 16, die ein erstes Torsionsfederelement 16₁ und ein zweites Torsionsfederelement 16₂ aufweist. Das Torsionsfederelement 16₁ ist an einem Kontaktbereich 18a mit dem mikromechanischen Element 12₁ mechanisch fest verbunden, beispielsweise durch eine Fixierung und/oder durch eine einstückige Verbindung oder Materialübergang, etwa bei einem Ätzvorgang oder dergleichen. An einem Kontaktbereich 18b ist das Torsionsfederelement 16₁ mechanisch fest mit dem mikromechanischen Element 12₂ verbunden. An einem Kontaktbereich 18c ist das Torsiqnsfederelement 16₂ mit dem mikromechanischen Element 12₁ und an einem Kontaktbereich 18d mit dem mikromechanischen Element 12₂ mechanisch fest verbunden, so dass die relative Bewegung der mikromechanischen Elemente 12₁ und 12₂ relativ zueinander um die Torsionsachse 14 durch eine zeitgleiche Verformung der Torsionsfederelemente 16₁ und 16₂ der Torsionsfederanordnung 16 erfolgt.

Fig. 1 zeigt ein Ausführungsbeispiel, bei dem die Torsionsfederelemente 16₁ und 16₂ eine gekrümmte Form aufweisen, das bedeutet, eine axiale Erstreckungsrichtung der Torsionsfederelemente 16₁ und 16₂ in der x/z-Ebene von dem mikromechanischen Element 12₁ hin zu dem mikromechanischen Element 12₂ und umgekehrt ist in der x/z-Ebene veränderlich, wobei diese Veränderung kontinuierlich ist, nämlich in Form eines elliptischen Bogens.

Das Torsionsfederelement 16₁ weist eine Mittellinie 22₁ auf, während das Torsionsfederelement 16₂ eine Mittellinie 22₂ aufweist. Die Mittellinien 22₁ und 22₂ können als diejenige, aeaebenenfalls virtuelle. Linie verstanden werden. die durch Verbindung derienigen Punkte erhalten werden kann, die erhalten werden, wenn eine Abmessung 24 senkrecht zu einer lokalen axialen Erstreckungsrichtung halbiert wird. Die Abmessung 24 kann dabei in der x/z-Ebene angegeben sein und beispielsweise, jedoch nicht einschränkend, als Federbreite verstanden werden, während eine Abmessung der Torsionsfederelemente 16₁ und 16₂ entlang einer hierzu senkrecht angeordneten y-Richtung als Federdicke verstanden werden kann. Die Mittellinie 22₁ und 22₂ kann insofern im Bereich der hälftigen Abmessung entlang der y-Richtung angeordnet sein. Aufgrund der gekrümmten Ausführung der axialen Erstreckung der Torsionsfederelemente 16₁ und 16₂ ist insofern auch die Mittellinie 22₁ bzw. 22₂ gekrümmt.

Das bedeutet, dass sich die Mittellinien 22 entlang axialer Erstreckungsrichtungen der Torsionsfederelemente 16₁ und 16₂ erstrecken.

Die Kontaktbereiche 18a und 18b sowie 18c und 18d können jeweils gegenüberliegend zueinander angeordnet sein. Ein Abstand 26 zwischen den Mittellinien 22₁ und 22₂ ist entlang des axialen Verlaufs der Torsionsfederelemente 16₁ und 16₂ sowie bei einem Verlauf von den Kontaktbereichen 18a und 18c hin zu den Kontaktbereichen 18b und 18d oder andersherum veränderlich.

Ausgehend von den Kontaktbereichen 18a und 18c hin zu den Kontaktbereichen 18b und 18d kann dabei insbesondere der Abstand 26 von einem anfänglichen Abstand 26₁ in einem ersten Bereich 28₁ abnehmend sein. Der Abstand 26 kann soweit abnehmen, bis er ein lokales oder globales Minimum in einem Abstandswert 26₂ erreicht; Der Abstand der Mittellinien 26₂ kann einen beliebigen Wert aufweisen, der hin zu kleinen Werten dadurch begrenzt ist, dass sich die Torsionsfederelemente 16₁ und 16₂ zwischen den Bereichen 28₁ und 28₂ nicht berühren oder überschneiden (verschmelzen). In einem an den Bereich 28₁ angrenzenden Bereich 28₂ kann der Abstand 26 wieder zunehmen, so dass ein Abstand der Mittellinien 22₁ und 22₂ im Bereich der Kontaktbereiche 18b und 18d hin zum Abstand 26₃ wieder angewachsen ist. Bevorzugt und zum Erhalten einer Geometrie entspricht der Abstand 26₃ dem Abstand 26₁. Beispielhafte Werte für MEMS-Federbreiten können von zumindest 100 nm bis maximal 200 µm variieren. Bevorzugt werden Werte im Bereich von zumindest 2 µm und höchstens 120 µm umgesetzt. Die Abstände, insbesondere der Abstand 26₂ kann bspw. einen Wert von zumindest 1,5 µm und höchstens 5 mm aufweisen, bevorzugt von zumindest 5 µm und höchstens 1 mm.

Der variierende Abstand 26 ist bevorzugt so ausgestaltet, dass die Torsionsfedern 16₁ und 16₂ sowohl in der Ruhelage als auch bei betriebsgemäßer oder auslegungsgemäßer Auslenkung berührungsfrei zueinander sind, um Beeinflussungen oder Beschränkungen der Bewegungen oder eine durch mechanischen Kontakt hervorgerufene Beschädigung zu vermeiden. In anderen Worten befinden sich die zwei Torsionsfedern 16₁ und 16₂ in einem Abstand zueinander, der die ungehinderte mechanische Auslenkbarkeit, das bedeutet, ohne Kollision der beiden Federelemente im rotatorisch ausgelenkten Zustand, der beiden Elemente 12₁ und 12₂ relativ zueinander ermöglicht und als Parameter eine Optimierung für die Auslenkung unter den eingestellten oder erforderlichen Kräften ermöglicht. Das bedeutet, dass durch weitere Simulationen und dabei variierte Parameter wie Federbreiten, Federabstände und Winkel sowie Querschnittänderunaen weiteres Optimierungspotential bzgl. der Zielparameter und z.B. mechanischen Spannungswerten besteht.

Obwohl das MMS 10 so dargestellt und beschrieben ist, das ausgehend von den Kontaktbereiche 18a und 18c der Abstand 26 in dem Bereich 28₁ abnehmend und in dem Abschnitt 28₂ zunehmend ist, ist es ebenso möglich, dass diese Reihenfolge vertauscht ist und in dem Abschnitt 28₁ zuerst eine Zunahme des Abstands erfolgt und in dem Abschnitt 28₂ eine Abnahme erfolgt, auch wenn die beschriebene Ausgestaltung die bevorzugte ist. Dies kann beispielsweise dadurch erhalten werden, indem die Positionen der Torsionsfederelemente 16₁ und 16₂ miteinander vertauscht werden oder, indem jedes der Federelemente 16₁ und 16₂ in der z/x-Ebene um 180 Grad gedreht wird, etwa durch Rotation um die z-Achse oder durch Spiegelung an der z/y-Ebene. Das bedeutet, dass das MMS 10 so gebildet sein kann, dass die Torsionsfederelemente 16₁ und 16₂ einander abgewandte Bogenöffnungen bilden.

Im Bereich geringer oder minimaler Abstände 26 ist eine Torsionssteifigkeit der Torsionsfederanordnung 16 vergleichsweise geringer als in Bereichen höherer Abstände. Gleichzeitig ermöglichen die hohen Abstände die Widerstandsfähigkeit gegenüber den parasitären Bewegungen, wobei die Widerstandsfähigkeit mit größerem Abstand erhöht wird. Durch eine Veränderung des Abstands unter Verwendung der Abschnitte 28₁ und 28₂ kann somit die hohe Widerstandsfähigkeit gegenüber parasitären Bewegungen erhalten werden und dabei eine geringe oder vernachlässigbare Erhöhung der Torsionssteifigkeit in Kauf genommen werden, so dass insgesamt eine hohe Effizienz des MMS 10 erhalten wird.

Gemäß einem Ausführungsbeispiel sind die Torsionsfederelemente 16₁ und 16₂ punktsymmetrisch um einen gemeinsamen Symmetriepunkt 32 angeordnet. Der Symmetriepunkt 32 ist so angeordnet, dass die Abschnitte 28₁ und 28₂ rale Ausdehnung entlang der z-Richtung aufweisen. Ferner ist der Symmetriepunkt 32 in der z/x-Ebene so angeordnet, dass er an einem Übergang zwischen den Abschnitten 28₁ und 28₂ mittig zwischen den dortigen Positionen der Mittellinien 22₁ und 22₂ angeordnet ist.

zugt, den Symmetriepunkt 32 auf der Torsionsachse 14 anzuordnen.

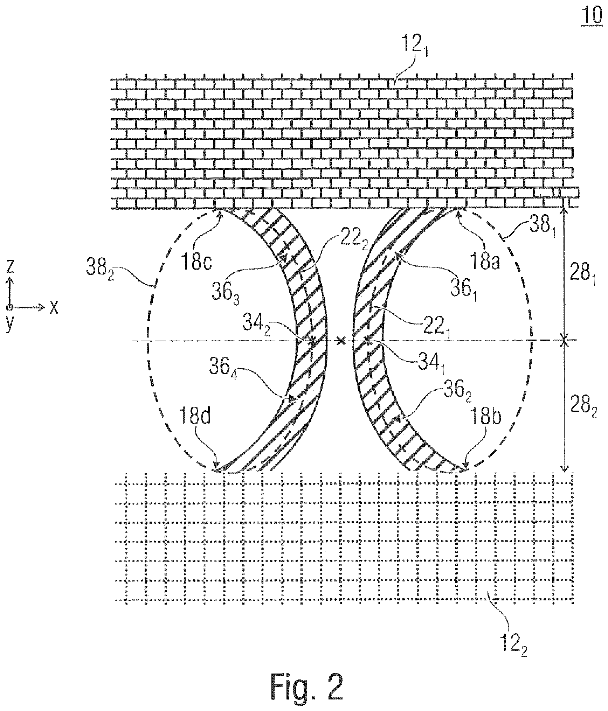

Gemäß den Ausführungsbeispielen der Fig. 1 und 2 sind die Mittellinien wie in Anspruch 1, wobei:
1. Die Ellipse kann ein Kreis sein;
2. Die Ellipse kann die lange oder kurze Halbachse parallel zur Torsionsachse,aufweisen;
3. Der Querschnitt der Viertel-Torsionsfeder kann nach außen hin linear zunehmen oder abnehmen;
4. Der Querschnitt der Viertel-Torsionsfeder kann nach außen hin nichtlinear zunehmen oder abnehmen;

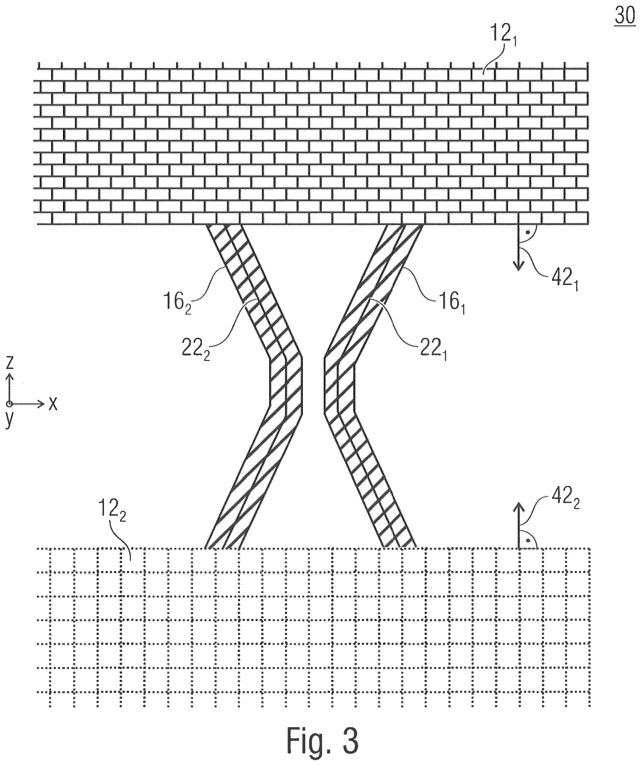

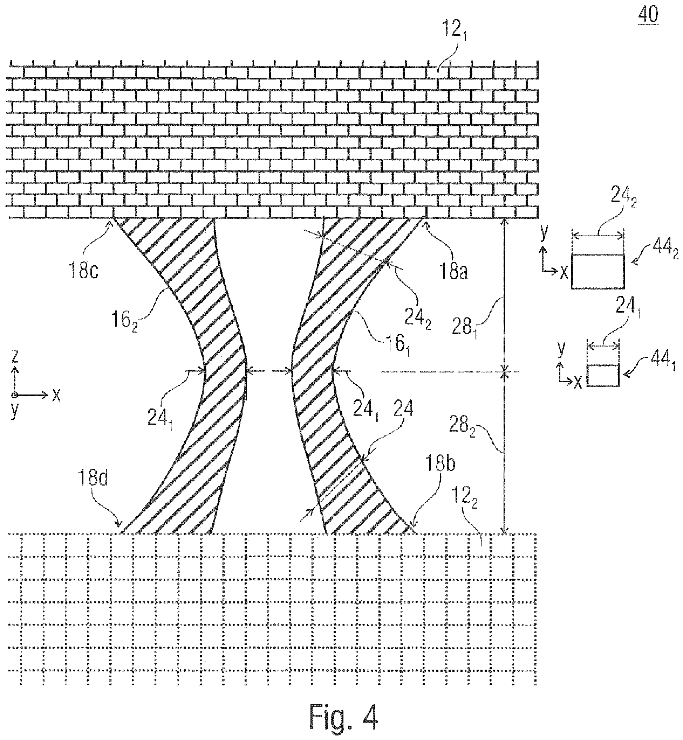

Gemäß anderen Ausführungsbeispielen kann die Mittellinie der Viertel-Torsionsfeder einen linearen, sich nach außen hin öffnenden Verlauf aufweisen, wie es beispielsweise in Fig. 3 dargestellt ist. Weitere Varianten sind beispielsweise, dass der Querschnitt der Viertel-Tbrsionsfäder nach außen hin linear zunimmt oder abnimmt (Fia.5) oder nichtlinear zunimmt öder abnimmt, siehe beispielsweise Fig. 4.

Die Form der Torsionsfedern bzw. die Torsionsfederanordnung 16 ist bspw. so gestaltet, dass sie im Vergleich zu einer einfachen Balkenfeder, die bspw. in Fig. 8a dargestellt ist, bei gleicher Torsionssteifigkeit eine erhöhte laterale (in-plane-Biegesteifigkeit) aufweist.

Fig. 2 zeigt eine mit Fig. 1 vergleichbare schematische Draufsicht auf das MMS 10. Die Mittellinien 22₁ und 22₂ beschreiben Ellipsenbahnen zwischen den Kontaktbereichen 18a und 18b bzw. 18c und 18d.

Ausgehend von den Mittelpunkten 34₁ bzw. 34₂ weist die Mittellinie 22₁ eine erste Seite 36₁ auf, die sich hin zu dem Kontaktbereich 18a erstreckt. Eine zweite, gegenüberliegende Seite 36₂ erstreckt sich zu dem Kontaktbereich 18b. Ausgehend von dem Mittelpunkt 34₂ weist die Mittellinie 22₂ eine erste Seite 36₃ auf, die sich zum Kontaktbereich 18c erstreckt und weist eine zweite Seite 36₄ auf, die sich zum Kontaktbereich 18d erstreckt. Die Seiten 36₁, 36₂, 36₃ und 36₄ können geometrisch ähnlich oder bevorzugt kongruent sein. Die Seiten 36₁, 36₂, 36₃ und 36₄ beschreiben jeweils eine Viertel-Ellipsen-Bahn.

Die Mittellinie 22₁ und/oder die Mittellinie 22₂ kann somit eine Halb-Ellipse bilden, wobei die Endpunkte der in den Mittelpunkten 34₁ und 34₂ verbundenen Viertel-Ellipsen-Bahnen eine Hauptachse der dargestellten Haupt-Ellipsen-Bahn 38₂ bzw. 38₂ oder eine Nebenachse hiervon bilden kann. Das bedeutet, dass gegenüberliegende oder abgewandte Enden der am Ort des jeweiligen Mittelpunktes 34₁ oder 34₂ verbundenen Viertel-Ellipsen-Bahnen eine durch eine Hauptachse oder Nebenachse der Ellipsenbahn 38₁ bzw. 38₂ bestimmt sein können. Gemäß einem Ausführungsbeispiel ist die Hauptachse und die Nebenachse dabei von gleicher Abmessung, das bedeutet, die Haupt-Ellipsen-Bahnen 38₁ und/oder 38₂ können auch eine Kreisform aufweisen.

In anderen Worten können bekannte Federformen, welche den Widerstand einer klassischen Torsionsfeder gegenüber translatorischen und rotatorischen Kräften in der Ebene erhöhen sollen, dies bei gleichbleibender Torsionssteifigkeit der Feder nicht leisten. Gemäß Ausführungsbeispielen wird dieses Problem gelöst. Die Torsionsfederanordnungen gemäß Ausführungsbeispielen ermöglichen es, eine traditionelle Balken-Torsionsfeder gemäß Fig. 8a durch eine Torsionsfeder(anordnung) mit erhöhter Widerstandskraft gegenüber lateralen Kräften bei gleichbleibender oder lediglich geringfügig erhöhter Torsionsfedersteifigkeit zu ersetzen. Die laterale Steifigkeit der neuartigen Torsionsfedern kann im Vergleich zu einer Balkenfeder beispielsweise um mindestens den Faktor 2 bis 3 erhöht werden, wobei auch andere Werte möglich sind.

Die beiden Torsionsfedern 16₁ und 16₂ sind über ihre gesamte Verlaufsform zwischen den Kontaktbereichen 18a und 18b bzw. 18c und 18d voneinander getrennt und können punktsymmetrisch angeordnet sein. Die Mittellinien der Torsionsfedern sind durch vier Viertel-Ellipsen-Bahnen beschrieben, die ihren Abstand von der Torsionsachse 14, beginnend von einem Mittelpunkt des Federsystems, nach außen hin vergrößern oder verkleinern. Unter Bezugnahme auf die Fig. 8a kann eine Torsionsfederanordnung 16 beispielsweise als Substitution der Torsionsfedern 1006₁ und/oder 1006₂ angeordnet werden.

Fig. 3 zeigt eine schematische Draufsicht auf ein MMS 30, bei dem die Torsionsfederanordnung 16 so gebildet ist, dass die Torsionsfederelemente 16₁ und 16₂ abschnittsweise gerade gebildet sind und gemäß einer X-Form angeordnet sind, wobei die Torsionsfederelemente 16₁ und 16₂ ungeachtet dessen kontaktfrei zueinander angeordnet sind.

Das bedeutet, anders als im MMS 10 können die Torsionsfederelemente 16₁ und 16₂ auch abschnittsweise gerade gebildet sein.

Obwohl die Mittellinien 22₁ und 22₂ so dargestellt sind, dass die Torsionsfederelemente 16₁ und 16₂ jeweils exakt zwei gerade Abschnitte miteinander kombinieren, kann auch eine andere, höhere Anzahl von geraden Abschnitten miteinander kombiniert werden, beispielsweise zumindest drei, zumindest vier, zumindest fünf oder zumindest sechs. Beispielsweise kann in einem Mittenbereich ein Abschnitt vorgesehen sein, der sich im Wesentlichen. d. h. innerhalb eines Toleranzbereichs von ±10°. ±5° oder ±1°. parallel zu einer Oberflächennormalen 42₁ oder 42₂ erstreckt, wobei die Oberflächennormale 42₁ und 42₂ auf eine Oberfläche bezogen ist, die einem jeweils anderen, gegenüberliegenden mikromechanischen Element 12₂ bzw. 12₁ zugewandt angeordnet ist.

Fig. 4 zeigt eine schematische Draufsicht auf ein MMS 40 gemäß einem Ausführungsbeispiel, wobei ein Querschnitt 44 der Torsionsfederelemente 16₁ und/oder 16₂ entlang eines axialen Verlaufs der jeweiligen Mittellinie bzw. des Torsionsfederelements 16₁ und 16₂ veränderlich ist. Hierfür kann zumindest eine der Abmessungen der Torsionsfederelemente 16₁ und/oder 16₂ in einer x/y-Ebene veränderlich sein. Einfach kann dies dadurch erhalten werden, dass die Torsionsfederelemente 16₁ und/oder 16₂ mit einer veränderlichen Breite 24 gebildet werden, die beispielsweise ausgehend von einer geringen oder minimalen Breite 24₁ in einem Mittenbereich hin zu den Kontaktbereichen 18a und 18b bzw. 18c und 18d zunimmt. Alternativ oder zusätzlich ist es ebenfalls möglich, eine Abmessung entlang der y-Richtung zu verändern. Die Veränderung der Abmessung entlang einer jeweiligen Richtung und/oder einer Kombination beider Richtungen ermöglicht die Beeinflussung der Torsionssteifigkeit des jeweiligen Elements in einem bestimmten lokalen Bereich. Die axiale Erstreckungsrichtung ist, wie erläutert, in einer Ebene der mikromechanischen Struktur, in der x/z-Ebene veränderlich. Der Querschnitt 44 der Torsionsfederelemente 16₁ und 16₂ senkrecht zu der axialen Erstreckungsrichtung kann ausgehend von Mittellinienmittelpunkten 34 veränderlich sein. Hier kommt in Betracht, eine lineare oder nichtlineare Zunahme zu implementieren. Alternativ kann auch eine lineare oder nichtlineare Abnahme erfolgen.

Die Zunahme oder Abnahme kann monoton oder gar streng monoton sein, was eine Kombination von Zunahme und Abnahme jedoch nicht ausschließt.

Ferner ist in Fig. 4 dargestellt, dass ein nicht-linearer Verlauf, d. h., Zu- und/oder Abnahme, eines Abstands zwischen den Torsionsfederelementen implementiert sein kann.

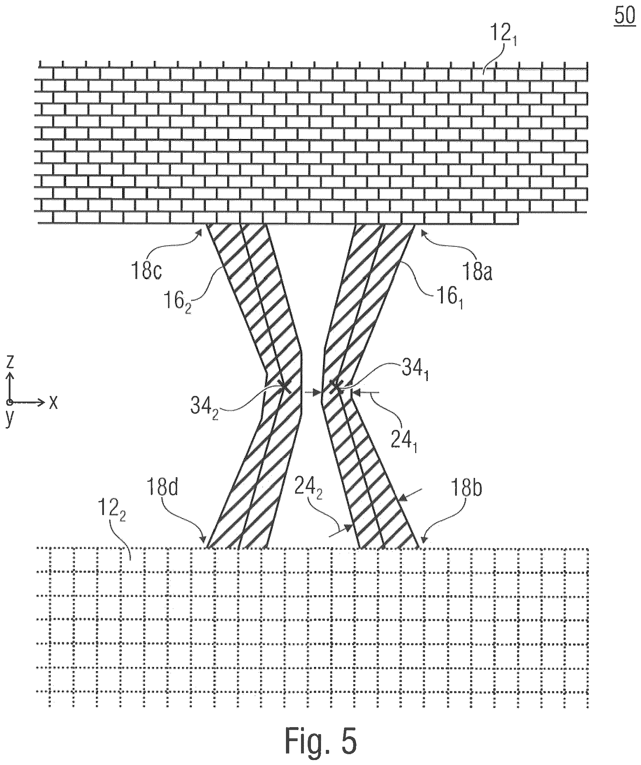

Fig. 5 zeigt eine schematische Draufsicht auf ein MMS 50, bei der gegenüber einer nichtlinearen Zunahme hin zu den Kontaktbereichen 18a bis 18d eine lineare Zunahme des Querschnitts bzw. der Federbreite 24 implementiert ist. Obwohl die nichtlineare Zunahme in Kombination mit einer gekrümmten Außenseite der Torsionsfederelemente, die durch eine nichtlineare Querschnittsänderung eines geraden Federverlaufs erhalten wird, in Fig. 4 beschrieben ist und eine lineare Zunahme in Fig. 5 mit einem abschnittsweisen geraden Verlauf der Torsionsfederelemente 16₁ und 16₂ beschrieben ist, ist es ohne Einschränkungen möglich, gekrümmte und gerade Abschnitte mit linearer oder nichtlinearer Zunahme oder Abnahme zu versehen.

Ferner ist in Fig. 5 dargestellt, dass ein linearer Verlauf, d. h., Zu- und/oder Abnahme, eines Abstands zwischen den Torsionsfederelementen implementiert sein kann.

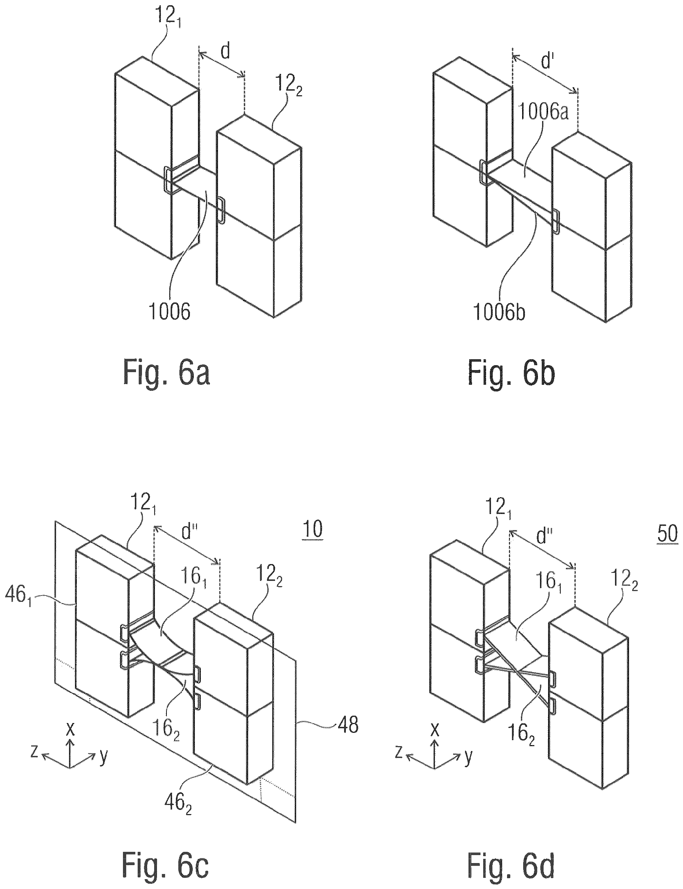

Fig. 6a zeigt eine schematische perspektivische Ansicht eines Simulationsmodells eines bekannten MMS, das eine einzelne Blattfeder 1006 zwischen mikromechanischen Elementen 12₁ und 12₂ aufweist und dabei einen dazwischenliegenden Abstand d überbrückt. Der Abstand d kann typischerweise in einem Bereich von zumindest 20 µm und höchstens 500-1000 µm liegen, etwa 100 µm.

Fig. 6b zeigt eine schematische perspektivische Ansicht eines Simulationsmodells eines bekannten MMS, das eine V-Feder-Anordnung mit zwei Blattfedern 1006a und 1006b aufweist, die zwischen den mikromechanischen Elementen 12₁ und 12₂ angeordnet sind und einen gegenüber dem Abstand d vergrößerten Abstand d' überbrücken, der in etwa 150 % bis 200 % von d beträgt.

Fig. 6c zeigt eine schematische perspektivische Ansicht eines Simulationsmodells des MMS 10, die eine weitere Eigenheit erfindungsgemäßer Ausführungsbeispiele darlegt. Die Torsionsfederelemente 16₁ und 16₂ können in einer gemeinsamen Ebene der mikromechanischen Struktur angeordnet sein, beispielsweise in einer Ebene parallel zu der x/z-Ebene. Diese Ebene kann gleichzeitig parallel zu einer Ebene einer Hauptoberfläche 46₁ und/oder 46₂ der mikromechanischen Elemente 12₁ bzw. 12₂ in einer Ruhelage der mikromechanischen Struktur angeordnet sein, das bedeutet, in einer Lage, in welcher die mikromechanischen Elemente 12₁ und 12₂ unausgelenkt zueinander sind. Ein Abstand d" zwischen den mikromechanischen Elementen 12₁ und 12₂ kann gegenüber dem Abstand d vergrößert sein, und bspw. in etwa 120 % bis 150 % von d betragen.

Ausführungsbeispiele sehen vor, dass neben den Torsionsfederelementen 16₁ und 16₂ auch das mikromechanische Element 12₁ und/oder 12₂ in der Ruhelage in der gemeinsamen Ebene angeordnet sind. Beispielsweise kann eine Ebene 48 parallel zu den Hauptoberflächen 46₁ und 46₂ in der Ruhelage sein. In der Ebene 48 können sowohl die mikromechanischen Elemente 12₁ und 12₂ als auch die Torsionsfederelemente 16₁ und 16₂ angeordnet sein.

In anderen Worten zeigt Fig. 6c eine Ansicht einer Bogen-Spalt-Torsionsfeder.

Fig. 6d zeigt eine schematische perspektivische Ansicht eines Simulationsmodells des MMS 30, bei dem, gegenüber dem MMS 10 die Torsionsfederelemente 16 und 16₂ als gerade Blattfedern gebildet sind, während das MMS 10 die Torsionsfederelemente 16₁ und 16₂ als kontinuierlich gebogene Blattfedern aufweist.

In anderen Worten zeigt Fig. 6d eine schematische perspektivische Ansicht einer X-Spalt-Torsionsfeder. Die Figuren 6a-d sind beispielhaft mit gleichen Größenverhältnissen dargestellt, um Unterschiede hervorzuheben, was jedoch nicht verhindert, dass unterschiedliche MEMS mit unterschiedlichen Abmessungen von den vorliegenden Ausführungsbeispielen umfasst sind.

Erneut Bezug nehmend auf Fig. 8a, kann eine beschriebene Torsionsfederanordnung bzw. ein hierin beschriebenes MMS, etwa das MMS 10, 30, 40 oder 50 an ein oder mehreren Stellen angeordnet sein, das bedeutet, dass zumindest eine zweite, aber auch eine höhere Anzahl von Torsionsfederanordnungen gemäß der hierin beschriebenen Ausführungsbeispiele angeordnet werden kann. Entlang der Torsionsachse 1016 kann eine weitere, zusätzliche Torsionsfederanordnung beispielsweise an jeweils gegenüberliegenden Seiten des mikromechanischen Elements 1004 angeordnet werden. Auch wenn eine gleiche Ausbildung der entlang einer einzelnen Torsionsachse angebrachten Torsionsfederanordnungen bevorzugt ist, können auch unterschiedlich gebildete Torsionsfederanordnungen angeordnet, werden, insbesondere wenn lediglich geringfügige Abweichungen bezüglich der Torsiorissteifigkeit vorliegen.

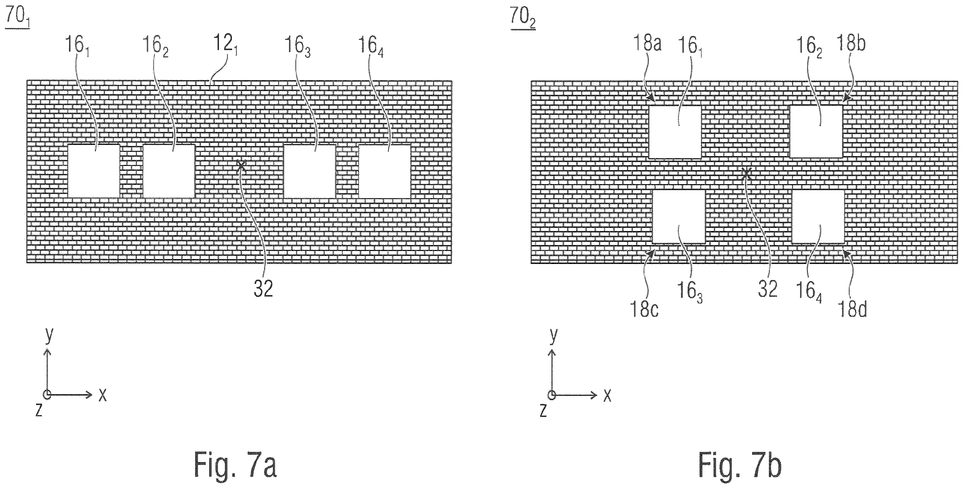

Fig. 7a zeigt eine schematische Seitenschnittansicht eines MEMS 70₁, bei dem die Torsionsfederanordnung eine verglichen mit zwei höhere Anzahl von Torsionsfedern 16₁ bis 16₄ aufweist, bspw. vier oder eine andere, bevorzugt geradzahligen Anzahl, die entlang einer Linie parallel zu der z-Richtung punktsymmetrisch um den Symmetriepunkt 32 angeordnet sind, was in diesem Fall mit einer Achssymmetrie um eine Achse parallel zu der y-Achse zur hälftigen Unterteilung der Torsionsfederelemente 16₁ bis 16₄ identisch sein kann. Die Anzahl kann einen beliebigen anderen Wert aufweisen, etwa 6, 8 oder mehr.

Fig. 7b zeigt eine schematische Seitenschnittansicht eines MEMS 70₂, bei dem die Torsionsfederanordnung ebenfalls eine verglichen mit zwei höhere Anzahl von Torsionsfedern 16₁ bis 16₄ aufweist, bspw. vier oder eine andere, bevorzugt geradzahligen Anzahl, die punktsymmetrisch um den Symmetriepunkt 32 angeordnet sind. Allerdings sind beim MEMS 70₂ die Torsionsfederelemente 16₁ bis 16₄ in zumindest zwei oder mehr Ebenen entlang der y-Richtung angeordnet und bilden bezüglich der Kontaktbereiche 18a-d ein Rechteckmuster. Bei einer höheren Anzahl von Torsionsfederelementen und/oder einer höheren Anzahl von Ebenen kann ohne weiteres ein beliebiges Polygon erhalten werden.

Bei den Ausführungen der MEMS 70₁ und 70₂ verbinden zumindest vier oder eine andere, höhere Anzahl von Torsionsfederelementen die mikromechanischen Elemente 12₁ und 12₂ um eine gemeinsame Torsionsachse, die beispielhaft am Ort des Symmetriepunktes 32 angeordnet ist oder diesen schneidet.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Mikromechanische Struktur (10, 30; 40; 50) mit:
einem ersten mikromechanischen Element (12₁);
einem zweiten mikromechanischen Element (12₂);
einer Torsionsfederanordnung (16) umfassend ein erstes, eine erste Mittellinie (22₁) aufweisendes Torsionsfederelement (16₁) das an einem ersten Kontaktbereich (18a) mit dem ersten mikromechanischen Element (12₁) und an einem zweiten Kontaktbereich (18b) mit dem zweiten mikromechanischen Element (12₂) mechanisch verbunden ist, und umfassend ein zweites, eine zweite Mittellinie (22₂) aufweisendes Torsionsfederelement (16₂) das an einem dritten Kontaktbereich (18c) mit dem ersten mikromechanischen Element (12₁) und an einem vierten Kontaktbereich (18d) mit dem zweiten mikromechanischen Element (12₂) mechanisch verbunden ist, um das erste mikromechanische Element (12₁) und das zweite mikromechanische Element (12₂) relativ zueinander beweglich zu verbinden;
wobei ein Abstand (26) zwischen der ersten Mittellinie (22₁) und der zweiten Mittellinie (22₂) ausgehend von dem ersten und dritten Kontaktbereich (18a, 18c) hin zu dem zweiten und vierten Kontaktbereich (18b, 18c) in einem ersten Abschnitt (28₁) abnehmend ist und in einem zweiten Abschnitt (28₂) zunehmend ist;
wobei das erste Torsionsfederelement (16₁) und das zweite Torsionsfederelement (16₂) in einer Ruhelage der mikromechanischen Struktur berührungsfrei zueinander angeordnet sind;
wobei die erste Mittellinie (22₁) einen ersten Mittelpunkt (34₁) aufweist und die zweite Mittellinie (22₂) einen zweiten Mittelpunkt (34₂) aufweist; **dadurch gekennzeichnet, dass**
auf einer ersten Seite (36₁) ausgehend von dem ersten Mittelpunkt (34₁) sich die erste Mittellinie (22₁) in einer Viertel-Ellipsen-Bahn hin zu dem ersten Kontaktbereich (18a) und auf einer zweiten, der ersten Seite gegenüberliegenden Seite (36₂) in einer Viertel-Ellipsenbahn hin zu dem zweiten Kontaktbereich (18b) erstreckt; und
wobei auf einer ersten Seite ausgehend von dem zweiten Mittelpunkt (34₂) sich die zweite Mittellinie (22₂) in einer Viertel-Ellipsen-Bahn hin zu dem dritten Kontaktbereich (18c) und auf einer zweiten, der ersten Seite gegenüberliegenden Seite in einer Viertel-Ellipsen-Bahn hin zu dem vierten Kontaktbereich (18d) erstreckt.

2. Mikromechanische Struktur gemäß Anspruch 1, bei der gegenüberliegende Enden zweier in dem ersten oder zweiten Mittelpunkt (34₁, 34₂) verbundener Viertel-Ellipsen-Bahnen eine Hauptachse einer Gesamt-Ellipsenbahn (38) oder eine Nebenachse der Gesamt-Ellipsenbahn (38) bilden.

3. Mikromechanische Struktur gemäß Anspruch 1 oder 2, bei der die Viertel-Ellipsen-Bahnen Viertel-Kreise sind.

4. Mikromechanische Struktur gemäß einem der vorangehenden Ansprüche, bei der der Abstand (26) zwischen den Mittellinien (22) in einem Bereich der Mittelpunkte (34₁, 34₂) ein Minimum aufweist und ausgehend von den Mittelpunkten (34₁, 34₂) hin zu dem ersten mikromechanischen Element (12₁) und hin zu dem zweiten mikromechanischen Element (12₂) zunimmt.

5. Mikromechanische Struktur gemäß einem der vorangehenden Ansprüche, bei der das erste mikromechanische Element (12₁) und/oder das zweite mikromechanische Element (12₂) ein optisches Element umfasst.

6. Mikromechanische Struktur gemäß einem der vorangehenden Ansprüche, bei der die Torsionsfederanordnung zumindest vier Torsionsfedern umfassend das erste Torsionsfederelement (16₁) und das zweite Torsionsfederelement (16₂) umfasst, die das erste mikromechanische Element (12₁) und das zweite mikromechanischen Element (12₂) um eine gemeinsame Torsionsachse verbinden.

7. Mikromechanische Struktur (10, 30; 40; 50) mit:
einem ersten mikromechanischen Element (12₁);
einem zweiten mikromechanischen Element (122);
einer Torsionsfederanordnung (16) umfassend ein erstes, eine erste Mittellinie (22₁) aufweisendes Torsionsfederelement (16₁) das an einem ersten Kontaktbereich (18a) mit dem ersten mikromechanischen Element (12₁) und an einem zweiten Kontaktbereich (18b) mit dem zweiten mikromechanischen Element (12₂) mechanisch verbunden ist, und umfassend ein zweites, eine zweite Mittellinie (22₂) aufweisendes Torsionsfederelement (16₂) das an einem dritten Kontaktbereich (18c) mit dem ersten mikromechanischen Element (12₁) und an einem vierten Kontaktbereich (18d) mit dem zweiten mikromechanischen Element (12₂) mechanisch verbunden ist, um das erste mikromechanische Element (12₁) und das zweite mikromechanische Element (12₂) relativ zueinander beweglich zu verbinden;
wobei ein Abstand (26) zwischen der ersten Mittellinie (22₁) und der zweiten Mittellinie (22₂) ausgehend von dem ersten und dritten Kontaktbereich (18a, 18c) hin zu dem zweiten und vierten Kontaktbereich (18b, 18c) in einem ersten Abschnitt (28₁) abnehmend ist und in einem zweiten Abschnitt (28₂) zunehmend ist;
wobei das erste Torsionsfederelement (16₁) und das zweite Torsionsfederelement (16₂) in einer Ruhelage der mikromechanischen Struktur berührungsfrei zueinander angeordnet sind; **dadurch gekennzeichnet, dass**
der Abstand (26) zwischen den Mittellinien (22) in einem Bereich von Mittelpunkten (34₁, 34₂) der Mittellinien ein Minimum aufweist und ausgehend von den Mittelpunkten (34₁, 34₂) hin zu dem ersten mikromechanischen Element (12₁) und hin zu dem zweiten mikromechanischen Element (12₂) zunimmt; und die Torsionsfederelemente (16₁, 162) abschnittsweise gerade gebildet sind und gemäß einer X-Form angeordnet sind, wobei die Torsionsfederelemente (16₁, 16₂) kontaktfrei zueinander angeordnet sind.

8. Mikromechanische Struktur gemäß einem der vorangehenden Ansprüche, bei der das erste Torsionsfederelement (16₁) und das zweite Torsionsfederelement (16₂) punktsymmetrisch um einen gemeinsamen SvmmetrieDunkt (32) gebildet sind.

9. Mikromechanische Struktur gemäß einem der vorangehenden Ansprüche, bei der sich die Mittellinien (22₁, 22₂) der Torsionsfederelemente (16₁, 16₂) entlang axialer Erstreckungsrichtungen der Torsionsfederelemente (16₁, 16₂) erstrecken, wobei die Erstreckungsrichtungen in einer Ebene der mikromechanischen Struktur Veränderlich sind, wobei ein Querschnitt (44) des ersten Torsionsfederelementes (16₁) und des zweiten Torsionsfederelementes (16₂) senkrecht zu der axialen Erstreckungsrichtung und ausgehend von den Mittelpunkten (34₁, 34₂) der Mittellinien linear (22₁, 22₂) oder nichtlinear zunimmt; oder linear oder nichtlinear abnimmt.

10. Mikromechanische Struktur gemäß Anspruch 9, bei der der Querschnitt (44) des ersten Torsionsfederelementes (16₁) und des zweiten Torsionsfederelementes (16₂) senkrecht zu der axialen Erstreckungsrichtung und ausgehend von den Mittelpunkten (34₁, 34₂) der Mittellinien (22₁, 22₂) linear oder nichtlinear zunimmt.

11. Mikromechanische Struktur gemäß Anspruch 9, bei der der Querschnitt (44) des ersten Torsionsfederelementes (16₁) und des zweiten Torsionsfederelementes (16₂) senkrecht zu der axialen Erstreckungsrichtung und ausgehend von den Mittelpunkten (34₁, 34₂) der Mittellinien (22₁, 22₂) linear oder nichtlinear streng monoton zunimmt.

12. Mikromechanische Struktur gemäß Anspruch 9, bei der der Querschnitt (44) des ersten Torsionsfederelementes (16₁) und des zweiten Torsionsfederelementes (16₂) senkrecht zu der axialen Erstreckungsrichtung und ausgehend von den Mittelpunkten (34₁, 34₂) der Mittellinien (22₁, 22₂) linear oder nichtlinear abnimmt.

13. Mikromechanische Struktur gemäß Anspruch 9, bei der der Querschnitt (44) des ersten Torsionsfederelementes (16₁) und des zweiten Torsionsfederelementes (16₂) senkrecht zu der axialen Erstreckungsrichtung und ausgehend von den Mittelpunkten (34₁, 34₂) der Mittellinien (22₁, 22₂) linear oder nichtlinear streng monoton abnimmt.

14. Verfahren zum Bereitstellen einer mikromechanischen Struktur mit folgenden Schritten:
Bereitstellen eines ersten mikromechanischen Elements (12₁);
Bereitstellen eines zweiten mikromechanischen Elements (12₂);
Anordnen einer Torsionsfederanordnung (16), mit einem ersten, eine erste Mittellinie (22₁) aufweisenden Torsionsfederelement (16₁), so dass dieses an einem ersten Kontaktbereich (18a) mit dem ersten mikromechanischen Element (12₁) und an einem zweiten Kontaktbereich (18b) mit dem zweiten mikromechanischen Element (12₂) mechanisch verbunden ist, und mit einer zweiten, eine zweite Mittellinie (22₂) aufweisenden Torsionsfederelement (16₂), so dass dieses an einem dritten Kontaktbereich (18c) mit dem ersten mikromechanischen Element (12₁) und an einem vierten Kontaktbereich (18d) mit dem zweiten mikromechanischen Element (12₂) mechanisch verbunden ist, um das erste mikromechanische Element (12₁) und das zweite mikromechanische Element (12₂) relativ zueinander beweglich zu verbinden;
so dass ein Abstand (26) zwischen der ersten Mittellinie (22₁) und der zweiten Mittellinie (22₁) ausgehend von dem ersten und dritten Kontaktbereich (18a, 18c) hin zu dem zweiten und vierten Kontaktbereich (18b, 18d) in einem ersten Abschnitt (28₁) abnehmend ist und in einem zweiten Abschnitt (28₁) zunehmend ist; und
so dass das erste Torsionsfederelement (16₁) und das zweite Torsionsfederelement (16₂) in einer Ruhelage der mikromechanischen Struktur berührungsfrei zueinander angeordnet sind; **dadurch gekennzeichnet, dass**
die erste Mittellinie (22₁) einen ersten Mittelpunkt (34₁) aufweist und die zweite Mittellinie (22₂) einen zweiten Mittelpunkt (34₂) aufweist;
so dass auf einer ersten Seite (36₁) ausgehend von dem ersten Mittelpunkt (34₁) sich die erste Mittellinie (22₁) in einer Viertel-Ellipsen-Bahn hin zu dem ersten Kontaktbereich (18a) und auf einer zweiten, der ersten Seite gegenüberliegenden Seite (36₂) in einer Viertel-Ellipsenbahn hin zu dem zweiten Kontaktbereich (18b) erstreckt; und
so dass auf einer ersten Seite ausgehend von dem zweiten Mittelpunkt (34₂) sich die zweite Mittellinie (22₂) in einer Viertel-Ellipsen-Bahn hin zu dem dritten Kontaktbereich (18c) und auf einer zweiten, der ersten Seite gegenüberliegenden Seite in einer Viertel-Ellipsen-Bahn hin zu dem vierten Kontaktbereich (18d) erstreckt.

15. Verfahren zum Bereitstellen einer mikromechanischen Struktur mit folgenden Schritten:
Bereitstellen eines ersten mikromechanischen Elements (12₁);
Bereitstellen eines zweiten mikromechanischen Elements (12₂);
Anordnen einer Torsionsfederanordnung (16), mit einem ersten, eine erste Mittellinie (22₁) aufweisenden Torsionsfederelement (16₁), so dass dieses an einem ersten Kontaktbereich (18a) mit dem ersten mikromechanischen Element (12₁) und an einem zweiten Kontaktbereich (18b) mit dem zweiten mikromechanischen Element (12₂) mechanisch verbunden ist, und mit einer zweiten, eine zweite Mittellinie (22₂) aufweisenden Torsionsfederelement (16₂), so dass dieses an einem dritten Kontaktbereich (18c) mit dem ersten mikromechanischen Element (12₁) und an einem vierten Kontaktbereich (18d) mit dem zweiten mikromechanischen Element (12₂) mechanisch verbunden ist, um das erste mikromechanische Element (12₁) und das zweite mikromechanische Element (12₂) relativ zueinander beweglich zu verbinden;
so dass ein Abstand (26) zwischen der ersten Mittellinie (22₁) und der zweiten Mittellinie (22₁) ausgehend von dem ersten und dritten Kontaktbereich (18a, 18c) hin zu dem zweiten und vierten Kontaktbereich (18b, 18d) in einem ersten Abschnitt (28₁) abnehmend ist und in einem zweiten Abschnitt (28₁) zunehmend ist; und
so dass das erste Torsionsfederelement (16₁) und das zweite Torsionsfederelement (16₂) in einer Ruhelage der mikromechanischen Struktur berührungsfrei zueinander angeordnet sind; **dadurch gekennzeichnet, dass**
der Abstand (26) zwischen den Mittellinien (22) in einem Bereich von Mittelpunkten (34₁, 34₂) der Mittellinien ein Minimum aufweist und ausgehend von den Mittelpunkten (34₁, 34₂) hin zu dem ersten mikromechanischen Element (12₁) und hin zu dem zweiten mikromechanischen Element (12₂) zunimmt; und die Torsionsfederelemente (16₁, 16₂) abschnittsweise gerade gebildet sind und gemäß einer X-Form angeordnet sind, so dass die Torsionsfederelemente (16₁, 16₂) kontaktfrei zueinander angeordnet sind.

## Claims

1. A micromechanical structure (10, 30; 40; 50) comprising:
a first micromechanical element (12₁);
a second micromechanical element (12₂);
a torsion spring arrangement (16) comprising a first torsion spring element (16₁), comprising a first center line (22₁), mechanically connected to the first micromechanical element (12₁) at a first contact region (18a) and to the second micromechanical element (12₂) at a second contact region (18b), and comprising a second torsion spring element (16₂), comprising a second center line (22₂), mechanically connected to the first micromechanical element (12₁) at a third contact region (18c) and to the second micromechanical element (12₂) at a fourth contact region (18d) in order to connect the first micromechanical element (12₁) and the second micromechanical element (12₂) to be movable relative to each other;
wherein a distance (26) between the first center line (22₁) and the second center line (22₂), starting from the first and third contact regions (18a, 18c) towards the second and fourth contact regions (18b, 18c), decreases in a first portion (28₁) and increases in a second portion (28₂);
wherein, in a rest position of the micromechanical structure, the first torsion spring element (16₁) and the second torsion spring element (16₂) are arranged without contact to each other;
wherein the first center line (22₁) comprises a first center (34₁) and the second center line (22₂) comprises a second center (34₂); **characterized in that**
the first center line (22₁), on a first side (36₁) starting from the first center (34₁), extends in a quarter ellipse path towards the first contact region (18a) and, on a second side (36₂) opposite the first side, in a quarter ellipse path towards the second contact region (18b); and
wherein the second center line (22₂), on a first side starting from the second center (34₂), extends in a quarter ellipse path towards the third contact region (18c) and, on a second side opposite the first side, in a quarter ellipse path towards the fourth contact region (18d).

2. The micromechanical structure in accordance with claim 1, wherein opposite ends of two quarter ellipse paths connected in the first or second center (34₁, 34₂) form a main axis of an overall ellipse path (38) or a minor axis of the overall ellipse path (38).

3. The micromechanical structure in accordance with claim 1 or 2, wherein the quarter ellipse paths are quarter circles.

4. The micromechanical structure in accordance with any of the preceding claims, wherein the distance (26) between the center lines (22) comprises a minimum in a region of the centers (34₁, 34₂) and increases starting from the centers (34₁, 34₂) towards the first micromechanical element (12₁) and towards the second micromechanical element (12₂).

5. The micromechanical structure in accordance with any of the preceding claims, wherein the first micromechanical element (12₁) and/or the second micromechanical element (12₂) comprise an optical element.

6. The micromechanical structure in accordance with any of the preceding claims, wherein the torsion spring arrangement comprises at least four torsion springs, comprising the first torsion spring element (16₁) and the second torsion spring element (16₂), which connect the first micromechanical element (12₁) and the second micromechanical element (12₂) around a common torsion axis.

7. A micromechanical structure (10, 30; 40; 50) comprising:
a first micromechanical element (12₁);
a second micromechanical element (12₂);
a torsion spring arrangement (16) comprising a first torsion spring element (16₁), comprising a first center line (22₁), mechanically connected to the first micromechanical element (12₁) at a first contact region (18a) and to the second micromechanical element (12₂) at a second contact region (18b), and comprising a second torsion spring element (16₂), comprising a second center line (22₂), mechanically connected to the first micromechanical element (12₁) at a third contact region (18c) and to the second micromechanical element (12₂) at a fourth contact region (18d) in order to connect the first micromechanical element (12₁) and the second micromechanical element (12₂) to be movable relative to each other;
wherein a distance (26) between the first center line (22₁) and the second center line (22₂), starting from the first and third contact regions (18a, 18c) towards the second and fourth contact regions (18b, 18c), decreases in a first portion (28₁) and increases in a second portion (28₂);
wherein, in a rest position of the micromechanical structure, the first torsion spring element (16₁) and the second torsion spring element (16₂) are arranged without contact to each other; **characterized in that**
wherein the distance (26) between the center lines (22) comprises a minimum in a region of centers (34₁, 34₂) of the center lines and increases starting from the centers (34₁, 34₂) towards the first micromechanical element (12₁) and towards the second micromechanical element (12₂); and the torsion spring elements (16₁, 16₂) are formed to be straight in sections and are arranged in accordance with an X shape, wherein the torsion spring elements (16₁, 16₂) are arranged without contact to each other.

8. The micromechanical structure in accordance with any of the preceding claims, wherein the first torsion spring element (16₁) and the second torsion spring element (16₂) are formed to be point-symmetrical around a common point of symmetry (32).

9. The micromechanical structure in accordance with any of the preceding claims, wherein the center lines (22₁, 22₂) of the torsion spring elements (16₁, 16₂) extend along axial extension directions of the torsion spring elements (16₁, 16₂), wherein the extension directions are variable in a plane of the micromechanical structure, wherein a cross-section (44) of the first torsion spring element (16₁) and of the second torsion spring element (16₂) increases linearly or non-linearly perpendicular to the axial extension direction and starting from the centers (34₁, 34₂) of the center lines (22₁, 22₂); or decreases linearly or non-linearly.

10. The micromechanical structure in accordance with claim 9, wherein the cross-section (44) of the first torsion spring element (16₁) and of the second torsion spring element (16₂) increases linearly or non-linearly perpendicular to the axial extension direction and starting from the centers (34₁, 34₂) of the center lines (22₁, 22₂).

11. The micromechanical structure in accordance with claim 9, wherein the cross-section (44) of the first torsion spring element (16₁) and of the second torsion spring element (16₂) increases linearly or non-linearly in a strictly monotonous way perpendicular to the axial extension direction and starting from the centers (34₁, 34₂) of the center lines (22₁, 22₂).

12. The micromechanical structure in accordance with claim 9, wherein the cross-section (44) of the first torsion spring element (16₁) and of the second torsion spring element (16₂) decreases linearly or non-linearly perpendicular to the axial extension direction and starting from the centers (34₁, 34₂) of the center lines (22₁, 22₂).

13. The micromechanical structure in accordance with claim 9, wherein the cross-section (44) of the first torsion spring element (16₁) and of the second torsion spring element (16₂) decreases linearly or non-linearly in a strictly monotonous way perpendicular to the axial extension direction and starting from the centers (34₁, 34₂) of the center lines (22₁, 22₂).

14. A method of providing a micromechanical structure, comprising the steps of:
providing a first micromechanical element (12₁);
providing a second micromechanical element (12₂);
arranging a torsion spring arrangement (16) comprising a first torsion spring element (16₁), comprising a first center line (22₁), such that it is mechanically connected to the first micromechanical element (12₁) at a first contact region (18a) and to the second micromechanical element (12₂) at a second contact region (18b), and comprising a second torsion spring element (16₂), comprising a second center line (22₂), such that it is mechanically connected to the first micromechanical element (12₁) at a third contact region (18c) and to the second micromechanical element (12₂) at a fourth contact region (18d) in order to connect the first micromechanical element (12₁) and the second micromechanical element (12₂) to be movable relative to each other;
such that a distance (26) between the first center line (22₁) and the second center line (22₂), starting from the first and third contact regions (18a, 18c) towards the second and fourth contact regions (18b, 18c), decreases in a first portion (28₁) and increases in a second portion (28₂); and
such that, in a rest position of the micromechanical structure, the first torsion spring element (16₁) and the second torsion spring element (16₂) are arranged without contact to each other; **characterized in that**
the first center line (22₁) comprises a first center (34₁) and the second center line (22₂) comprises a second center (34₂);
such that the first center line (22₁), on a first side (36₁) starting from the first center (341), extends in a quarter ellipse path towards the first contact region (18a) and, on a second side (36₂) opposite the first side, in a quarter ellipse path towards the second contact region (18b); and
such that the second center line (22₂), on a first side starting from the second center (34₂), extends in a quarter ellipse path towards the third contact region (18c) and, on a second side opposite the first side, in a quarter ellipse path towards the fourth contact region (18d).

15. A method of providing a micromechanical structure, comprising the steps of:
providing a first micromechanical element (12₁);
providing a second micromechanical element (12₂);
arranging a torsion spring arrangement (16) comprising a first torsion spring element (16₁), comprising a first center line (22₁), such that it is mechanically connected to the first micromechanical element (12₁) at a first contact region (18a) and to the second micromechanical element (12₂) at a second contact region (18b), and comprising a second torsion spring element (16₂), comprising a second center line (22₂), such that it is mechanically connected to the first micromechanical element (12₁) at a third contact region (18c) and to the second micromechanical element (12₂) at a fourth contact region (18d) in order to connect the first micromechanical element (12₁) and the second micromechanical element (12₂) to be movable relative to each other;
such that a distance (26) between the first center line (22₁) and the second center line (22₁), starting from the first and third contact regions (18a, 18c) towards the second and fourth contact regions (18b, 18c), decreases in a first portion (28₁) and increases in a second portion (28₂); and
such that, in a rest position of the micromechanical structure, the first torsion spring element (16₁) and the second torsion spring element (16₂) are arranged without contact to each other; **characterized in that**
the distance (26) between the center lines (22) comprises a minimum in a region of centers (34₁, 34₂) of the center lines and increases starting from the centers (34₁, 34₂) towards the first micromechanical element (12₁) and towards the second micromechanical element (12₂); and the torsion spring elements (16₁, 16₂) are formed to be straight in sections and are arranged in accordance with an X shape, wherein the torsion spring elements (16₁, 16₂) are arranged without contact to each other.

## Revendications

1. Structure micromécanique (10, 30; 40; 50) avec:
un premier élément micromécanique (12₁);
un deuxième élément micromécanique (12₂);
un aménagement de ressorts de torsion (16) comportant un premier élément de ressort de torsion (16₁) présentant une première ligne centrale (22₁), qui est connecté mécaniquement, au niveau d'une première zone de contact (18a), au premier élément micromécanique (12₁) et, au niveau d'une deuxième zone de contact (18b), au deuxième élément micromécanique (12₂) et comportant un deuxième élément de ressort de torsion (16₂) présentant une deuxième ligne centrale (22₂), qui est connecté mécaniquement, au niveau d'une troisième zone de contact (18c), au premier élément micromécanique (12₁) et, au niveau d'une quatrième zone de contact (18d), au deuxième élément micromécanique (12₂), pour connecter le premier élément micromécanique (12₁) et le deuxième élément micromécanique (12₂) de manière mobile l'un par rapport à l'autre;
dans laquelle une distance (26) entre la première ligne centrale (22₁) et la deuxième ligne centrale (22₂) est, en partant de la première et de la troisième zone de contact (18a, 18c) vers la deuxième et la quatrième zone de contact (18b, 18c), décroissante dans un premier segment (28₁) et est croissante dans un deuxième segment (28₂);
dans laquelle le premier élément de ressort de torsion (16₁) et le deuxième élément de ressort de torsion (16₂) sont disposés, dans une position de repos de la structure micromécanique, sans contact l'un avec l'autre;
dans laquelle la première ligne centrale (22₁) présente un premier point central (34₁) et la deuxième ligne centrale (22₂) présente un deuxième point central (34₂); **caractérisée par le fait que**
d'un premier côté (36₁), en partant du premier point central (34₁), la première ligne centrale (22₁) s'étend selon un trajet en quart d'ellipse vers la première zone de contact (18a) et, d'un deuxième côté (36₂) opposé au premier côté, selon un trajet en quart d'ellipse vers la deuxième zone de contact (18b); et
dans laquelle, d'un premier côté, en partant du deuxième point central (34₂), la deuxième ligne centrale (22₂) s'étend selon un trajet en quart d'ellipse vers la troisième zone de contact (18c) et, d'un deuxième côté opposé au premier côté, selon un trajet en quart d'ellipse vers la quatrième zone de contact (18d).

2. Structure micromécanique selon la revendication 1, dans laquelle les extrémités opposées de deux trajets en quart d'ellipse connectés au premier ou au deuxième point central (34₁, 34₂) forment un axe principal d'un trajet elliptique global (38) ou un axe auxiliaire du trajet elliptique global (38).

3. Structure micromécanique selon la revendication 1 ou 2, dans laquelle les trajets en quart d'ellipse sont des quarts de cercle.

4. Structure micromécanique selon l'une des revendications précédentes, dans laquelle la distance (26) entre les lignes centrales (22) présente un minimum dans une zone des points centraux (34₁, 34₂) et augmente à partir des points centraux (34₁, 34₂) vers le premier élément micromécanique (12₁) et vers le deuxième élément micromécanique (12₂).

5. Structure micromécanique selon l'une des revendications précédentes, dans laquelle le premier élément micromécanique (12₁) et/ou le deuxième élément micromécanique (12₂) comporte un élément optique.

6. Structure micromécanique selon l'une des revendications précédentes, dans laquelle l'aménagement de ressorts de torsion comporte au moins quatre ressorts de torsion comportant le premier élément de ressort de torsion (16₁) et le deuxième élément de ressort de torsion (16₂) qui connectent le premier élément micromécanique (12₁) et le deuxième élément micromécanique (12₂) autour d'un axe de torsion commun.

7. Structure micromécanique (10, 30; 40; 50) avec:
un premier élément micromécanique (12₁);
un deuxième élément micromécanique (12₂);
un aménagement de ressorts de torsion (16) comportant un premier élément de ressort de torsion (16₁) présentant une première ligne centrale (22₁), qui est connecté mécaniquement, au niveau d'une première zone de contact (18a), au premier élément micromécanique (12₁) et, au niveau d'une deuxième zone de contact (18b), au deuxième élément micromécanique (12₂) et comportant un deuxième élément de ressort de torsion (16₂) présentant une deuxième ligne centrale (22₂), qui est connecté mécaniquement, au niveau d'une troisième zone de contact (18c), au premier élément micromécanique (12₁) et, au niveau d'une quatrième zone de contact (18d), au deuxième élément micromécanique (12₂), pour connecter le premier élément micromécanique (12₁) et le deuxième élément micromécanique (12₂) de manière mobile l'un par rapport à l'autre;
dans laquelle une distance (26) entre la première ligne centrale (22₁) et la deuxième ligne centrale (22₂) est, en partant de la première et de la troisième zone de contact (18a, 18c) vers la deuxième et la quatrième zone de contact (18b, 18c), décroissante dans un premier segment (28₁) et croissante dans un deuxième segment (28₂);
dans laquelle le premier élément de ressort de torsion (16₁) et le deuxième élément de ressort de torsion (16₂) sont disposés, dans une position de repos de la structure micromécanique, sans contact l'un avec l'autre; **caractérisée par le fait que**
la distance (26) entre les lignes centrales (22) présente un minimum dans une zone de points centraux (34₁, 34₂) des lignes centrales et augmente en partant des points centraux (34₁, 34₂) vers le premier élément micromécanique (12₁) et vers le deuxième élément micromécanique (12₂); et les éléments de ressort de torsion (16₁, 16₂) sont formés droites par segment et sont disposés en forme de X, où les éléments de ressort de torsion (16₁, 16₂) sont disposés sans contact l'un avec l'autre.

8. Structure micromécanique selon l'une des revendications précédentes, dans laquelle le premier élément de ressort de torsion (16₁) et le deuxième élément de ressort de torsion (16₂) sont formés à symétrie ponctuelle autour d'un point de symétrie commun (32).

9. Structure micromécanique selon l'une des revendications précédentes, dans laquelle les lignes centrales (22₁, 22₂) des éléments de ressort de torsion (16₁, 16₂) s'étendent dans des directions d'extension axiale des éléments de ressort de torsion (16₁, 16₂), dans laquelle les directions d'extension sont variables dans un plan de la structure micromécanique, dans laquelle une section transversale (44) du premier élément de ressort de torsion (16₁) et du deuxième élément de ressort de torsion (16₂) augmente de manière linéaire ou non linéaire, ou diminue de manière linéaire ou non linéaire, perpendiculairement à la direction d'extension axiale et en partant des points centraux (34₁, 34₂) des lignes centrales (22₁, 22₂).

10. Structure micromécanique selon la revendication 9, dans laquelle la section transversale (44) du premier élément de ressort de torsion (16₁) et du deuxième élément de ressort de torsion (16₂) augmente de manière linéaire ou non linéaire perpendiculairement à la direction d'extension axiale et en partant des points centraux (34₁, 34₂) des lignes centrales (22₁, 22₂).

11. Structure micromécanique selon la revendication 9, dans laquelle la section transversale (44) du premier élément de ressort de torsion (16₁) et du deuxième élément de ressort de torsion (16₂) augmente de manière strictement monotone linéairement ou non linéairement perpendiculairement à la direction d'extension axiale et en partant des points centraux (34₁, 34₂) des lignes centrales (221, 22₂).

12. Structure micromécanique selon la revendication 9, dans laquelle la section transversale (44) du premier élément de ressort de torsion (16₁) et du deuxième élément de ressort de torsion (16₂) diminue de manière linéaire ou non linéaire perpendiculairement à la direction d'extension axiale et en partant des points centraux (341, 34₂) des lignes centrales (22₁, 22₂).

13. Structure micromécanique selon la revendication 9, dans laquelle la section transversale (44) du premier élément de ressort de torsion (16₁) et du deuxième élément de ressort de torsion (16₂) diminue de manière strictement monotone linéairement ou non linéairement perpendiculairement à la direction d'extension axiale et en partant des points centraux (34₁, 34₂) des lignes centrales (22₁, 22₂).

14. Procédé permettant de mettre à disposition une structure micromécanique, aux étapes suivantes consistant à:
prévoir un premier élément micromécanique (12₁);
prévoir un deuxième élément micromécanique (12₂);
disposer un aménagement de ressorts de torsion (16) avec un premier élément de ressort de torsion (16₁) présentant une première ligne centrale (22₁) de sorte que ce dernier soit connecté mécaniquement, au niveau d'une première zone de contact (18a), au premier élément micromécanique (12₁) et, au niveau d'une deuxième zone de contact (18b), au deuxième élément micromécanique (12₂), et avec un deuxième élément de ressort de torsion (16₂) présentant une deuxième ligne centrale (22₂), de sorte que ce dernier soit connecté mécaniquement, au niveau d'une troisième zone de contact (18c), au premier élément micromécanique (12₁) et, au niveau d'une quatrième zone de contact (18d), au deuxième élément micromécanique (12₂), pour connecter le premier élément micromécanique (12₁) et le deuxième élément micromécanique (12₂) de manière mobile l'un par rapport à l'autre;
de sorte qu'une distance (26) entre la première ligne centrale (22₁) et la deuxième ligne centrale (22₁), en partant de la première et de la troisième zone de contact (18a, 18c) vers la deuxième et la quatrième zone de contact (18b, 18d), soit décroissante dans un premier segment (28₁) et soit croissante dans un deuxième segment (28₁); et
de sorte que le premier élément de ressort de torsion (16₁) et le deuxième élément de ressort de torsion (16₂) soient disposés, dans une position de repos de la structure micromécanique, sans contact l'un avec l'autre; **caractérisé par le fait que**
la première ligne centrale (22₁) présente un premier point central (34₁) et la deuxième ligne centrale (22₂) présente un deuxième point central (34₂);
de sorte que d'un premier côté (36₁), en partant du premier point central (34₁), la première ligne centrale (22₁) s'étende selon un trajet en quart d'ellipse vers la première zone de contact (18a) et, d'un deuxième côté (36₂) opposé au premier côté, selon un trajet en quart d'ellipse vers la deuxième zone de contact (18b); et
de sorte que d'un premier côté, en partant du deuxième point central (34₂), la deuxième ligne centrale (22₂) s'étende selon un trajet en quart d'ellipse vers la troisième zone de contact (18c) et, d'un deuxième côté opposé au premier côté, selon un trajet en quart d'ellipse vers la quatrième zone de contact (18d).

15. Procédé permettant de mettre à disposition une structure micromécanique, aux étapes suivantes consistant à:
prévoir un premier élément micromécanique (12₁);
prévoir un deuxième élément micromécanique (12₂);
disposer un aménagement de ressorts de torsion (16) avec un premier élément de ressort de torsion (16₁) présentant une première ligne centrale (22₁) de sorte que ce dernier soit connecté mécaniquement, au niveau d'une première zone de contact (18a), au premier élément micromécanique (12₁) et, au niveau d'une deuxième zone de contact (18b), au deuxième élément micromécanique (12₂), et avec un deuxième élément de ressort de torsion (16₂) présentant une deuxième ligne centrale (222), de sorte que ce dernier soit connecté mécaniquement, au niveau d'une troisième zone de contact (18c), au premier élément micromécanique (12₁) et, au niveau d'une quatrième zone de contact (18d), au deuxième élément micromécanique (12₂), pour connecter le premier élément micromécanique (12₁) et le deuxième élément micromécanique (12₂) de manière mobile l'un par rapport à l'autre;
de sorte qu'une distance (26) entre la première ligne centrale (22₁) et la deuxième ligne centrale (22₁), en partant de la première et de la troisième zone de contact (18a, 18c) vers la deuxième et la quatrième zone de contact (18b, 18d), soit décroissante dans un premier segment (28₁) et soit croissante dans un deuxième segment (28₁); et
de sorte que le premier élément de ressort de torsion (16₁) et le deuxième élément de ressort de torsion (16₂) soient disposés, dans une position de repos de la structure micromécanique, sans contact l'un avec l'autre; **caractérisé par le fait que**
la distance (26) entre les lignes centrales (22) présente un minimum dans une zone de points centraux (34₁, 34₂) des lignes centrales et augmente en partant des points centraux (34₁, 34₂) vers le premier élément micromécanique (12₁) et vers le deuxième élément micromécanique (12₂); et les éléments de ressort de torsion (16₁, 162) sont formés droits par segment et sont disposés en forme de X, de sorte que les éléments de ressort de torsion (16₁, 16₂) soient disposés sans contact l'un avec l'autre.
